# EUROPEAN PATENT SPECIFICATION

(11) **EP 1 881 334 B1**
(45) Date of publication and mention of the grant of the patent: **01.09.2010**
(21) Application number: 06117553.5
(22) Date of filing: 20.07.2006
(51) Int. Cl.: G01R 33/46, G06F 17/18, G01N 24/08

(54) **Metabolite Profiling Normalisation**
Normierung von Metabolitprofilen
Normalisation de profilage métabolite

(43) Date of publication of application: 23.01.2008
(73) Proprietor: BlueGnome Ltd, Cambridge, Cambridgeshire CB4 0WS (GB)
(72) Inventor: Craig, Andrew, Great Shelford, Cambridgeshire CB2 5LD (GB); Haan, Nick, Great Shelford, Cambridgeshire CB2 5LD (GB); Tham, Shien Shin, Great Shelford, Cambridgeshire CB2 5LD (GB); Punskaya, Elena, Cambridge CB1 8RG (GB)
(74) Representative: Haley, Stephen

(56) References cited:
- US-A1- 2003 111 596
- DIETERLE F ET AL: "Probabilistic quotient normalization as robust method to account for dilution of complex biological mixtures. Application in<1>H NMR metabonomics" ANALYTICAL CHEMISTRY 01 JUL 2006 UNITED STATES, vol. 78, no. 13, 1 July 2006 (2006-07-01), pages 4281-4290, XP002410886 ISSN: 0003-2700
- CRAIG A ET AL: "Scaling and normalization effects in NMR spectroscopic metabonomic data sets" ANALYTICAL CHEMISTRY 01 APR 2006 UNITED STATES, vol. 78, no. 7, 1 April 2006 (2006-04-01), pages 2262-2267, XP002410887 ISSN: 0003-2700

## Description

The present invention is related to metabolic profiling. Metabolic profiling is concerned with applying analytical chemistry techniques to characterize the metabolite composition of biological fluids such as urine or blood plasma, tissues and also media and materials derived from cell culture. Of these analytical techniques, Proton Nuclear Magnetic Resonance (¹H NMR) spectroscopy has been widely used to perform rapid non destructive metabolic profiling of biofluids in applications related to drug toxicity assessment as well as diagnosis and investigation of disease processes.

The spectrum acquired for each biological sample can be considered as a "metabolic fingerprint" which is indicative of the natural history of the organism from which the sample was obtained. For example, the "metabolic fingerprint" of two individuals treated with the same drug might be expected to exhibit similar features and should differ from the fingerprint of a third individual treated with a different drug.

Depending on the nature of the sample being analysed and the way in which the analysis is performed, it may not be meaningful to compare raw metabolic profile data from different samples directly. This problem arises when data is obtained from samples where the volumes and or concentrations of the different samples to be compared are not directly comparable.

For example, the volume and "gross" concentration of urine produced by a healthy individual may vary significantly and, typically, a fixed volume aliquot of each sample is used for analysis by NMR or MS. It is not therefore biologically meaningful to directly compare the amounts of a given metabolite between such different samples. A more biologically meaningful way to compare a metabolite in urine between samples is to express the data as an excretion rate (such as amount of metabolite / unit time /unit body weight). Similar considerations will also apply to any situation where recovery of sample material may vary between individuals leading to analysis of differing amounts of material for each sample.

There are two basic approaches to finding a solution to the problem of providing biologically meaningful data. The first is that of physically manipulating the samples and the second is that of performing post-processing on the data measured from each sample.

One physical technique for standardising samples prior to analysis is by freeze-drying and then reconstituting equivalent amounts of the recovered solutes from each sample in a fixed volume of a solvent to account for variable dilution of samples. However, it is unrealistic to freeze-dry and reconstitute all samples in an experiment and this approach is time consuming and unreliable, in that it may lead to a loss of volatile analytes from a sample.

Another physical normalization strategy which has been developed is to express all data in reference to a "reference" metabolite or to the concentration of a specific metabolite which has been determined by an independent assay. However, the use of an independent assay may be limited by the availability of samples as well as the sensitivity and specificity of the assay.

Thus, in order to solve the problems associated with the above strategies, a second approach was developed which uses data transformations to compensate for gross inter-sample variations. This allows a sample to be analysed directly, without additional preparation steps and eliminates the need for a separate assay method.

Consequently, several methods of data transformation have been developed in order to normalize metabolite profiles. In the art of metabolic profiling, the term "normalisation" is used to describe these mathematical operations carried out on raw data.

The most common approach to normalisation is a method which expresses each of the features within a single observation (spectrum) as a fraction of the sum total of all the feature values resulting in unit total intensity of each spectrum. This method is known as "normalisation to a constant sum", "total intensity" or "total area" normalisation as well as normalisation "by closure". This method provides a computationally efficient way of improving the comparability of a set of samples. However, there are several disadvantages associated with this method.

For series of spectra with highly similar internal peak ratios, constant sum normalisation approximates the relative concentration of species with adequate precision. However, this approximation will break down when large asymmetric perturbations occur to intensities in some spectra. For example, diabetic urine contains large amounts of glucose and, in addition, the urinary excretion of glucose in a diabetic is associated with the production of large volumes of dilute urine. If the method of constant sum normalization is used in a situation where several, but not all, samples are taken from a diabetic, some features will be increased (i.e. glucose). If the final observation is then normalised to a constant sum, other features will be comparatively decreased, thereby confounding straightforward interpretation of the analysis of such data. Furthermore, when constant sum normalization is used in similar situations, the correlation contains valuable information related to the chemical identities of the analytes. Using constant sum normalisation in similar situations will ultimately lead to the between-feature correlation information being lost or distorted.

In addition, large perturbations in some spectra are typical in many real-world studies. For example, in the case of drug toxicity studies, treated samples are expected to have high concentrations of drug metabolites. Accordingly, the samples will have a set of significantly increased features, thereby rendering standard constant sum normalisation ineffective.

To remedy this, prior art methods have sought to exclude significantly increased peaks from consideration. However, in order to be excluded, such regions must first be identified, which is not always practicable. Furthermore, different samples may have different perturbed areas with no common "stable" regions across the spectra. This is often the case in clinical studies of a disease when certain patients may have to take additional drugs to treat other conditions. Other prior art systems can be found disclosed in US 2003/111596, DIETERLE F ET AL: "Probabilistic quotient normalization as robust method to account for dilution of complex biological mixtures, Application in,<1>H NRM metabonomics" and CRAIG A ET AL: Scaling and normalization effects in NMR spectroscopic metabonomic data sets".

For instance, the article Dieterle F. et al, Analytical Chemistry, vol. 78, no. 13, 2006 discloses a method of normalizing a set of digital sample spectra, comprising the steps of calculating, for each sample spectrum, the ratio between each value in the sample spectrum and the corresponding value in a reference spectrum; constructing a histogram of the values calculated in the calculating step; finding a maximum and projecting that maximum onto the abscissa of the histogram; calculating a statistical measure of the projected value of the maximum; and adjusting the intensity of each sample spectrum by dividing the spectral data by the value found in the step of calculating the statistical measure of the projected value of each maximum, such that the sample spectra are normalized.

For the determination of the reference spectrum, it is suggested to employ a single spectrum of the study, a "golden" reference spectrum from a database, or a calculated median or mean spectrum on the basis of all spectra of the study or on the basis of a subset of the study.

Thus, there is a need for an effective and computationally simple method of normalizing metabolic profiles which allows straightforward biological interpretation of changes in feature magnitudes as well as preservation of chemical information contained in the between-feature correlations.

In order to solve the problems associated with the prior art, the present invention provides a method of normalizing a set of digital sample spectra for metabolic profiling, in accordance with claim 1.

Preferably, the reference spectra is determined to be the set of digital sample spectra.

Preferably, the step of choosing the reference spectra further comprises the step of:
selecting at least one predetermined spectral band from each sample spectrum as the set of reference spectra.

Preferably, the log-ratio is a logarithm base 2.

The present invention further comprises a system for normalizing a set of digital sample spectra for metabolic profiling in accordance with claim 5.

Preferably, the reference spectra is determined to be the set of digital sample spectra.

Preferably, the choosing means further comprises:
spectral band selection means arranged to select at least one predetermined spectral band from each sample spectrum as the set of reference spectra.

Preferably, the log-ratio is a logarithm base 2.

The present invention provides several advantages over the prior art. One significant advantage is that the normalization method according to the present invention allows straightforward biological interpretation of changes in feature magnitudes as well as preservation of the chemical information contained in between-feature correlations.

An example of the present invention will now be described with reference to the accompanying drawings in which:
Figure 1 is a comparison of data obtained from diabetic urine and control urine samples;
Figure 2 is a block diagram of a system in accordance with the present invention;
Figure 3 is a block diagram of a method in accordance with a first example of the present invention;
Figure 4A shows raw spectral data for a plurality of control urine samples;
Figure 4B shows raw spectral data for a plurality of diabetic urine samples;
Figure 5A shows the spectra of Figure 4A after having been normalised to constant sum;
Figure 5B shows the spectra of Figure 4B after having been normalised to a constant sum;
Figure 6A shows the spectra of Figure 4A after having been normalised in accordance with the method of the present invention;
Figure 6B shows the spectra of Figure 4B after having been normalised in accordance with the method of the present invention.

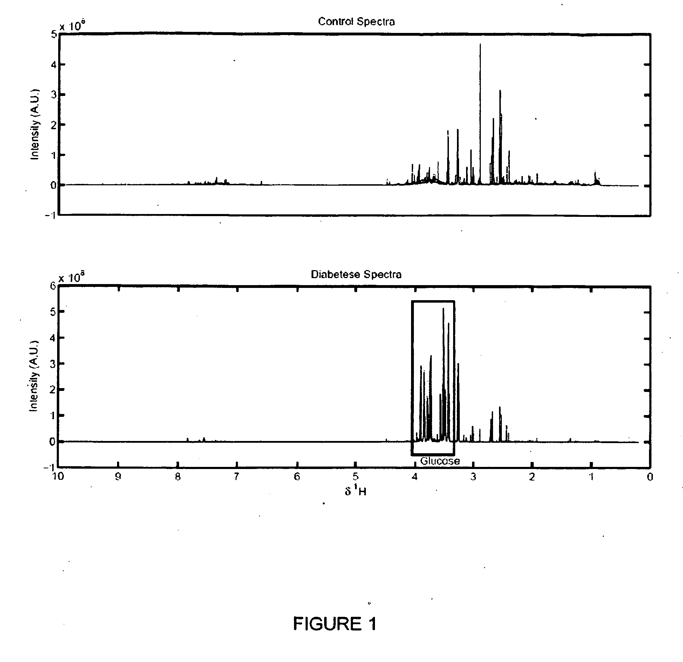

Figure 1 is an example of a typical normalization challenge. The upper panel shows raw spectral data for control urine. The lower panel shows spectral data for diabetic urine containing elevated levels of glucose. The highly elevated glucose peaks represent a large asymmetric perturbation in the metabolic composition of the sample. In addition, the gross concentration of the diabetic samples with respect to other endogenous metabolites is very low because of the diuretic effect of high urinary glucose excretion.

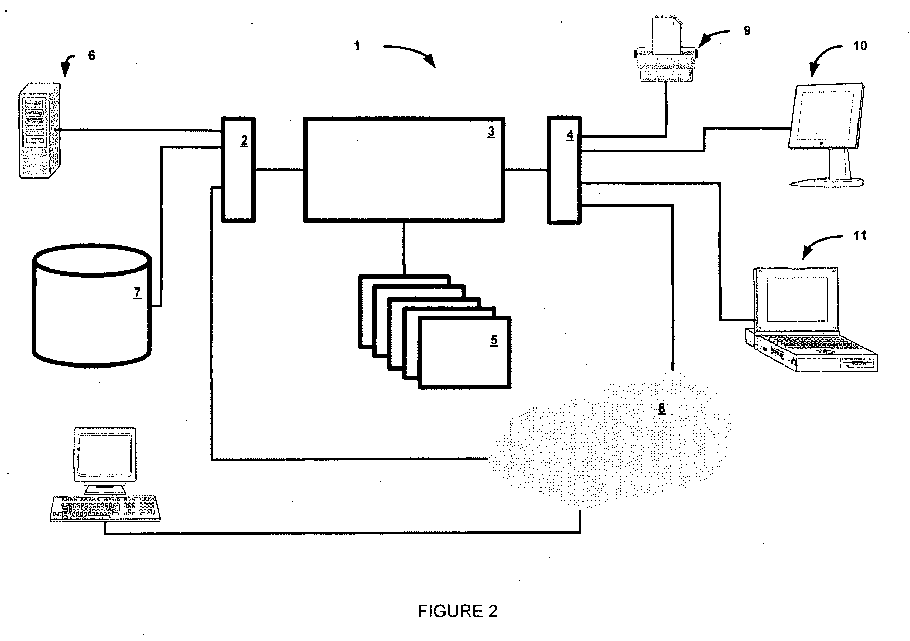

Figure 2 shows a system in accordance with the present invention. The system 1 of the present invention comprises input means 2 which may be directly connected to any form of spectroscopic device 7, a Compact Disk (CD) drive or any other form of memory device 6 which contains raw spectroscopic data or directly to a network 8. The system 1 further comprises memory means 5 for storing raw and processed data and processing means 3 for processing the data in accordance with the method of the present invention. Finally, the system 1 comprises output means 4. The output means 4 may be connected to display means 10, printer means 9 or another system 11 which may use the normalised data for other purposes. The output means may also be connected directly to a network 8.

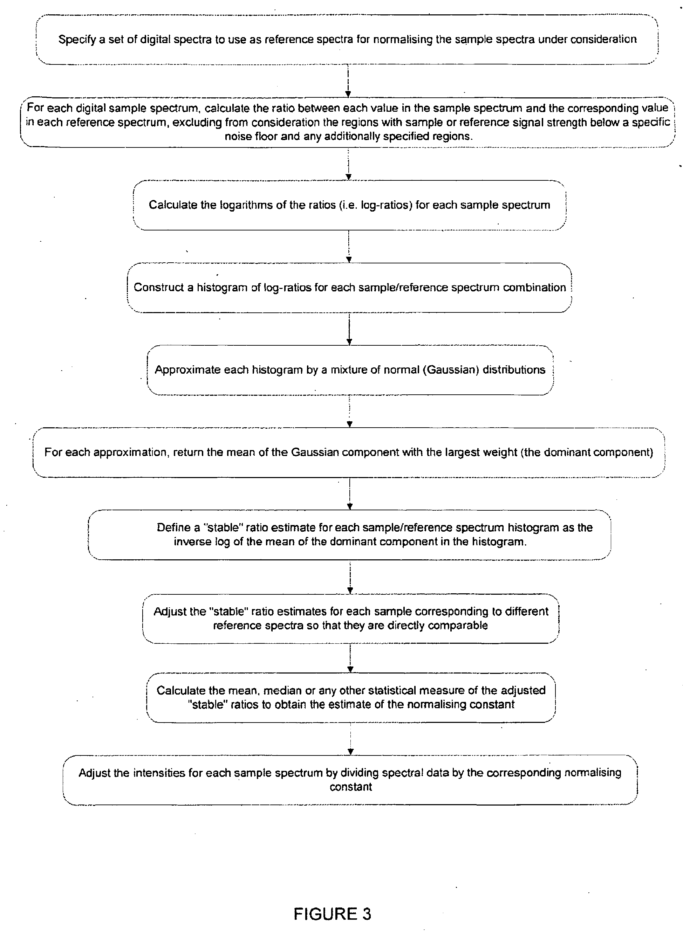

In reference to Figure 3, the present invention provides a generic preprocessing method that involves the normalization of data from each sample spectrum in order to make the spectra comparable with each other. The basic idea is to determine a set of stable features for a given series of samples that represent the common aspects of the metabolism of the sample organisms, and then normalise each spectrum based on this stable set so that the between-feature correlation structure of a data set is preserved.

The present invention is a method which is to be applied to a series of sample spectra. The first step in the method of the present invention is the selection of a set of reference spectra which will be used as a reference for normalizing the data set under consideration. A set of reference spectra can include any number of spectra chosen randomly or systematically from the data set under consideration (i.e. the sample spectra).

For example, an experiment may be performed to develop a classification algorithm which discriminates between healthy and diseased samples. In such a case, another batch of samples could be analysed with a view to using the classifier to predict whether samples come from healthy or diseased patients. In this situation, it may be useful to normalise the prediction data set using the same set of reference spectra which were used to normalise the training data set on which the classifier was developed to ensure that the prediction data set is directly comparable to the training data.

The next step in the method of the present invention is to calculate, for each sample spectrum, the "stable" ratio between each value in the sample spectrum and the corresponding value in each reference spectra. During this step, regions with sample or signal strength which are below a specific noise floor may be excluded. Also, other, pre-defined regions may be excluded such as noise bands, water and urea/allantoin areas for Nuclear Magnetic Resonance spectra or any other unreliable spectral regions.

For example, if urine samples from two different healthy individuals from similar backgrounds are compared and the first individual's sample is concentrated where as the second individual's sample is dilute, it would be reasonable to expect the majority of the metabolites to be common to both samples and that a number of metabolites would be present in approximately the same relative amounts in both individuals. However, other metabolites may be present in differing relative amounts because of, for example, genetic differences or differences in diet. If ratios are calculated between the two samples for each metabolite, those metabolites present in the same relative amounts should yield a consistent ratio. This is what is what is referred to as a "stable" ratio. Thus, stable ratios reflect the concentration difference between samples. For metabolites present in differing relative amounts, the ratio will deviate from the "stable" ratio as it will reflect both the difference in sample concentration and also the difference in relative amount of metabolite.

The method of the present invention operates on the spectral data points directly and assumes that these are a proxy for working directly with metabolites. In order to do this, some sections of the spectrum are not used. As mentioned above, regions are only compared if they contain signals above the noise floor of both spectra and regions which are known to contain distorted or unreliable signals are also discounted.

Then, using the ratios found in the previous step, the logarithms of the ratios (i.e. log-ratios) for each sample spectrum is calculated and a histogram of the log-ratios for each sample/reference spectrum combination is constructed. Log-ratio comparisons are typically but not necessarily expressed as logarithms base 2.

The next step in the method comprises approximating each histogram by a mixture of normal (Gaussian) distributions. A bin width parameter for the construction of the histogram may be selected by cross-validation on the selected set of spectra according to various known techniques. For example, one technique which may be used is that disclosed in Richardson, S. And Green, P.J. "On Bayesian analysis of mixtures with an unknown number of components", Journal of the Royal Statistical Society, Series B, 59, 731-792, 1997. However, other known methods could also be used.

Once the histograms have been approximated, the Gaussian component with the highest peak (the dominant component) is returned. Next, a "stable" ratio estimate for each sample/reference spectrum combination is defined as the inverse log of the mean of the dominant component for that sample/reference spectrum.

The dominant component maximum is projected onto the x axis and the inverse log of the x axis value is taken to give a stable ratio estimate.

Then, the stable ratio estimates for each sample corresponding to different reference spectra are adjusted such that they are directly comparable. The stable ratio estimates for each sample corresponding to different reference spectra are re-normalised with respect to a specific spectrum. This spectrum could be specified by a user through a variety of methods. An example fo this would be to re-normalise all stable ratio estimates with respect to one reference spectrum at a time and choose the reference spectrum which produces the most stable set of estimates.

In a simple case where three spectra (A, B and C) are to be normalized, it would be possible to use the three spectra themselves as reference spectra for normalisation. This would produce the following matrix of stable ratio estimates, with unitary values along the diagonal representing normalisation of a spectrum with itself:

| | | |
|---|---|---|
| 1 | B/A | C/A |
| A/B | 1 | C/B |
| A/C | B/C | 1 |

Part of the method of the present invention consists of estimating normalising factors using the stable ratios estimated using each of the reference spectra. However, a problem arises because the reference spectra normalised with respect to each other and so the stable ratio estimates are on different scales. The method of the present invention overcomes this problem using the abovementioned adjustment procedure.

The first step in the adjustment procedure is to linearly transform the stable ratio estimate matrix one row at a time so that all values in a selected column equal one. This is equivalent to putting all the stable ratio estimates onto a common scale.

The second step in the adjustment procedure is to measure the stability of this result by calculating the sum of the standard deviations of each row of the adjusted matrix. The column which gives the smallest sum of standard deviations is then selected for the final result.

Once the stable ratio estimates have been adjusted, the next step in the method consists of, for each sample spectrum, calculating the mean, median or any other statistical measure of their corresponding adjusted stable ratios to obtain the estimate of the normalising constant.

Finally, normalization is completed by dividing the spectral data of each sample by its corresponding normalisation constant.

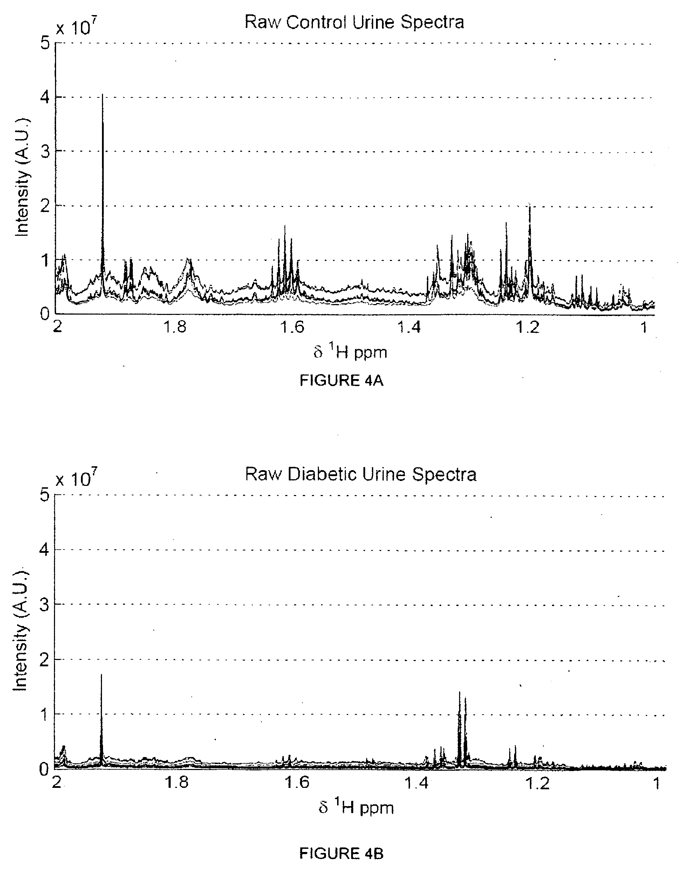

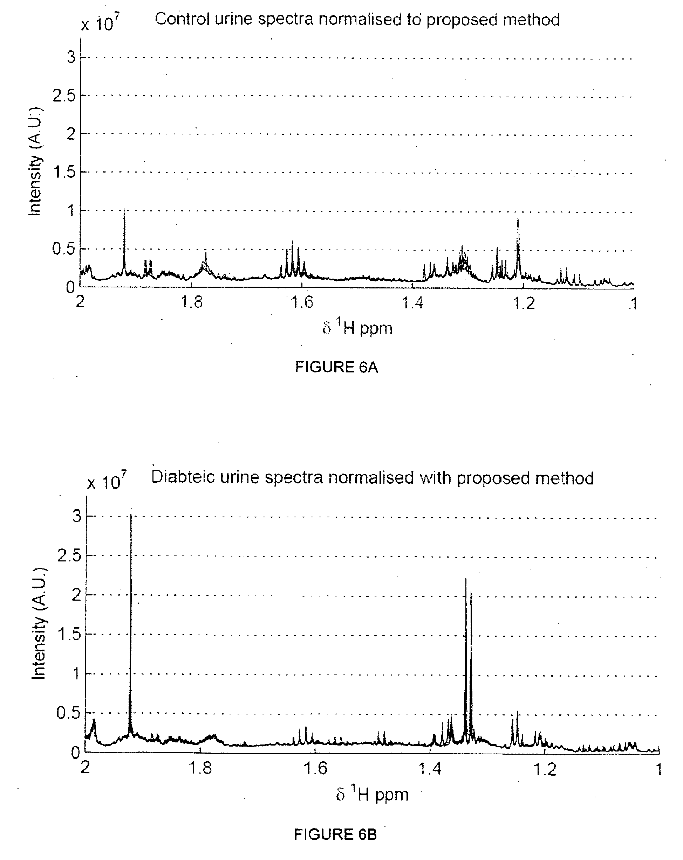

Figure 4A and 4B represent an enlargement of a region of the spectra presented in Figure 1. The set of samples represented in Figure 6A is from control urine and the set of samples represented in Figure 4B is from diabetic urine.

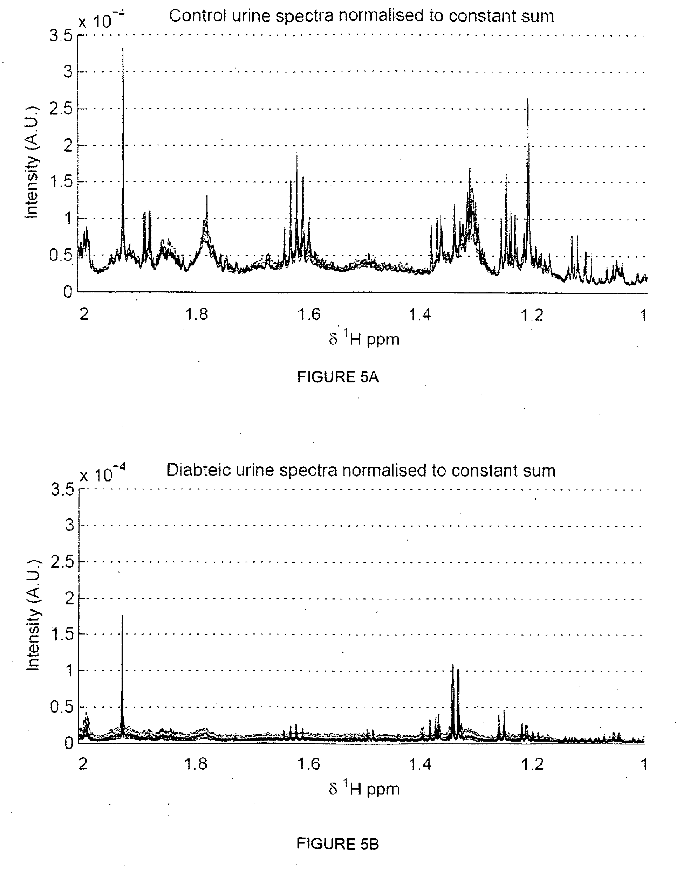

Figures 5A and 5B represent the normalisation to a constant sum of the samples of Figure 4A and 4B, respectively. It can clearly be seen that, because of the presence of the large glucose peaks in the diabetic samples, normalisation to a constant sum forces other peaks in the data as well as the baseline to appear to be decreased.

It is well known that the large singlet peak at 1.94 ppm of acetate is elevated in diabetic urine. When constant sum normalisation is applied to this exemplar diabetic data, the acetate peak appears higher in the control samples of Figure 5A than in the diabetic samples of Figure 5B, demonstrating a serious shortcoming of the constant sum approach and preventing straightforward interpretation of the changes in spectra between different experimental conditions.

Figures 6A and 6B represent the normalisation in accordance with the present invention of the samples of Figures 4A and 4B, respectively. It can clearly be seen from Figures 6A and 6B that the method of the present invention normalizes the data correctly, matching the intensities of many endogenous peaks while minimizing baseline disruptions due to the presence of large glucose peaks in the diabetic data.

Moreover, the acetate peak at 1.94ppm of the diabetic samples of Figure 6B is higher than in that of the control sample of Figure 6A, as would be expected in this situation. Thus, it is clear that the variation in the data related to the biological experiment has been preserved by this normalisation method. It is therefore also clear that the approach of the present invention facilitates straightforward interpretation of observed changes in spectra relating to different experimental conditions.

## Claims

1. A method of normalizing a set of digital sample spectra for metabolic profiling, the set of digital sample spectra comprising a series of spectroscopic features, the method comprising the steps of:
choosing a subset of the sample spectra as reference spectra;
calculating, for each sample spectrum, the ratio or the log-ratio between each value in the sample spectrum and the corresponding value in each reference spectrum;
constructing, for each combination of sample spectrum and reference spectrum, a histogram of the values calculated in the calculating step;
approximating each histogram constructed in the constructing step;
finding, for each approximation found in the approximation step, a maximum and projecting that maximum onto the abscissa of the histogram;
adjusting the projected value of each maximum such that they are directly comparable;
calculating a statistical measure of the adjusted projected value of each maximum; and
adjusting the intensity of each sample spectrum by dividing the spectral data by the value found in the step of calculating the statistical measure of the adjusted projected value of each maximum,such that,
the sample spectra are normalized and correlation between the spectroscopic features in each sample spectrum is preserved.

2. The method of claim 2, wherein the reference spectra is determined to be the set of digital sample spectra.

3. The method of any of claims 1 to 2, wherein the step of choosing the reference spectra further comprises the step of:
selecting at least one predetermined spectral band from each sample spectrum as the set of reference spectra.

4. The method of claim 1, wherein the log-ratio is a logarithm base 2.

5. A system for normalizing a set of digital sample spectra for metabolic profiling, the set of digital sample spectra comprising a series of spectroscopic features, the system comprising:
choosing means arranged to choose a subset of the sample spectra as reference spectra;
ratio calculating means arranged to calculate, for each sample spectrum, the ratio or log-ratio between each value in the sample spectrum and the corresponding value in each reference spectrum;
histogram constructing means arranged to construct, for each combination of sample spectrum and reference spectrum, a histogram of the values calculated in the calculating step;
approximating means arranged to approximate each histogram constructed by the histogram constructing means;
maximum finding means arranged to find, for each approximation found by the approximating means, a maximum and projecting that maximum onto the abscissa of the histogram;
adjusting means arranged to adjust the projected value of each maximum such that they are directly comparable;
statistical measure calculating means arranged to calculate a statistical measure of the adjusted projected value of each maximum; and
intensity adjusting means arranged to adjust the intensity of each sample spectrum by dividing spectral data by the value found in the step of calculating a statistical measure of the adjusted projected value of each maximum such that,
the sample spectra are normalized and correlation between the spectroscopic features in each sample spectrum is preserved.

6. The system of claim 5, wherein the reference spectra is determined to be the set of digital sample spectra.

7. The system of any of claims 5 to 6, wherein the choosing means further comprises:
spectral band selection means arranged to select at least one predetermined spectral band from each sample spectrum as the set of reference spectra.

8. The system of claim 5, wherein the log-ratio is a logarithm base 2.

## Patentansprüche

1. Methode für das Normieren einer Gruppe digitaler Probenspektren für das Bestimmen des metabolischen Profils, wobei die Gruppe digitaler Probenspektren eine Reihe spektroskopischer Merkmale umfasst, wobei die Methode folgende Schritte umfasst:
das Wählen einer Untergruppe der Probenspektren als Bezugsspektren;
das Berechnen für jedes Probenspektrum des Verhältnisses oder des log. Verhältnisses zwischen jedem Wert in dem Probenspektrum und dem entsprechenden Wert in jedem Bezugsspektrum;
das Konstruieren für jede Kombination von Probenspektrum und Bezugsspektrum eines Histogramms der im Berechnungsschritt errechneten Werte;
das Approximieren jedes Histogramms, das im Konstruktionsschritt konstruiert worden ist;
das Auffinden eines Maximums für jede im Approximationsschritt gefundene Approximation und das Projizieren des Maximums auf die Abszisse des Histogramms;
das Abstimmen des projizierten Werts jedes Maximums derart, dass sie direkt vergleichbar sind;
das Berechnen eines statistischen Messwerts des abgestimmten projizierten Werts jedes Maximums; und
das Abstimmen der Intensität jedes Probenspektrums durch Teilen der Spektraldaten durch den Wert, der im Schritt des Berechnens des statistischen Messwerts des abgestimmten projizierten Werts jedes Maximums gefunden worden ist, derart, dass
die Probenspektren normiert werden und die Korrelation zwischen den spektroskopischen Merkmalen in jedem Probenspektrum beibehalten wird.

2. Methode nach Anspruch 2, wobei festgelegt wird, dass die Bezugsspektren die Gruppe digitaler Probenspektren ist.

3. Methode nach einem der Ansprüche 1 bis 2, wobei der Schritt des Wählens der Bezugsspektren des Weiteren den Schritt umfasst des:
Auswählens mindestens einer vorbestimmten Spektralbande aus jedem Probenspektrum als Gruppe von Bezugsspektren.

4. Methode nach Anspruch 1, wobei das log. Verhältnis ein Logarithmus Base-2 ist.

5. System für das Normieren einer Gruppe digitaler Probenspektren für das Bestimmen des metabolischen Profils, wobei die Gruppe digitaler Probenspektren eine Reihe spektroskopischer Merkmale umfasst, wobei das System Folgendes umfasst:
das Wählen einer Möglichkeit, die zum Wählen einer Untergruppe der Probenspektren als Bezugsspektren angeordnet ist;
eine Verhältnisberechnungsmöglichkeit, die angeordnet ist, um für jedes Probenspektrum dass Verhältnis oder log. Verhältnis zwischen jedem Wert in dem Probenspektrum und dem entsprechenden Wert in jedem Bezugsspektrum zu berechnen;
eine Histogrammkonstruktionsmöglichkeit, die angeordnet ist, um für jede Kombination von Probenspektrum und Bezugsspektrum ein Histogramm der im Berechnungsschritt errechneten Werte zu konstruieren;
eine Approximiermöglichkeit, die angeordnet ist, um jedes Histogramm, das durch die Histogrammkonstruktionsmöglichkeit konstruiert worden ist, zu approximieren;
eine Maximumauffindungsmöglichkeit, die angeordnet ist, um für jede durch die Approximiermöglichkeit gefundene Approximation ein Maximum zu finden und das Maximum auf die Abszisse des Histogramms zu projizieren;
eine Abstimmmöglichkeit, die angeordnet ist, um den projizierten Wert jedes Maximums derart abzustimmen, dass sie direkt vergleichbar sind;
eine Möglichkeit für das Berechnen eines statistischen Messwerts, die angeordnet ist, um einen statistischen Messwert des abgestimmten projizierten Werts jedes Maximums zu berechnen; und
eine Intensitätsabstimmungsmöglichkeit, die angeordnet ist, um die Intensität jedes Probenspektrums durch Teilen der Spektraldaten durch den Wert, der im Schritt des Berechnens eines statistischen Messwerts des abgestimmten projizierten Werts jedes Maximums gefunden worden ist, abzustimmen, derart, dass
die Probenspektren normiert werden und die Korrelation zwischen den spektroskopischen Merkmalen in jedem Probenspektrum beibehalten wird.

6. System nach Anspruch 5, wobei festgelegt wird, dass die Bezugsspektren die Gruppe digitaler Probenspektren ist.

7. System nach einem der Ansprüche 5 bis 6, wobei die Wählmöglichkeit des Weiteren:
eine Spektralbandenauswählmöglichkeit umfasst, die angeordnet ist, um mindestens eine vorbestimmte Spektralbande aus jedem Probenspektrum als Gruppe von Bezugsspektren auszuwählen.

8. System nach Anspruch 5, wobei das log. Verhältnis ein Logarithmus Base-2 ist.

## Revendications

1. Méthode de normalisation d'un ensemble de spectres échantillons numériques pour le profilage métabolique, ledit ensemble de spectres échantillons numériques comprenant une série de caractéristiques spectroscopiques, la méthode comprenant les étapes qui consistent à :
choisir un sous-ensemble de spectres échantillons en tant que spectres témoins ;
calculer, pour chaque spectre échantillon, le rapport ou le rapport log entre chaque valeur dans le spectre échantillon et la valeur correspondante dans chaque spectre témoin ;
construire, pour chaque association de spectre échantillon et de spectre témoin, un histogramme des valeurs calculées dans l'étape de calcul ;
approximer chaque histogramme construit à l'étape de construction ;
trouver, pour chaque approximation trouvée à l'étape d'approximation, un maximum et projeter ce maximum sur l'axe des abscisses de l'histogramme ;
ajuster la valeur projetée de chaque maximum afin qu'elles soient directement comparables ;
calculer une valeur statistique de la valeur projetée ajustée de chaque maximum ; et
ajuster l'intensité de chaque spectre échantillon en divisant les données spectrales par la valeur trouvée à l'étape de calcul de la mesure statistique de la valeur projetée ajustée de chaque maximum, de telle sorte que,
les spectres échantillons soient normalisés et que la corrélation entre les caractéristiques spectroscopiques dans chaque spectre échantillon soit conservée.

2. Méthode selon la revendication 1, dans laquelle les spectres témoins sont déterminés comme étant l'ensemble de spectres échantillons numériques.

3. Méthode selon l'une quelconque des revendications 1 à 2, dans laquelle l'étape qui consiste à choisir les spectres témoins comprend, en outre, les étapes qui consistent à :
sélectionner au moins une bande spectrale prédéterminée à partir de chaque spectre échantillon comme étant l'ensemble de spectres témoins.

4. Méthode selon la revendication 1, dans laquelle le rapport log est un logarithme de base 2.

5. Système de normalisation d'un ensemble de spectres échantillons numériques pour le profilage métabolique, l'ensemble des spectres échantillons numériques comprenant une série de caractéristiques spectroscopiques, ledit système comprenant :
des moyens de sélection disposés pour choisir un sous-ensemble de spectres échantillons comme étant les spectres témoins ;
des moyens de calcul disposés pour calculer, pour chaque spectre échantillon, le rapport ou le rapport log entre chaque valeur dans le spectre échantillon et la valeur correspondante dans chaque spectre témoin ;
des moyens de construction d'histogrammes disposés pour construire, pour chaque association de spectre échantillon et de spectre témoin, un histogramme des valeurs calculées à l'étape de calcul ;
des moyens d'approximation disposés pour approximer chaque histogramme construit par les moyens de construction d'histogrammes ;
des moyens de recherche de maxima disposés pour trouver, pour chaque approximation trouvée par les moyens d'approximation, un maximum et projeter ce maximum sur l'axe des abscisses de l'histogramme ;
des moyens d'ajustement disposés pour ajuster la valeur projetée de chaque maximum afin qu'elles soient directement comparables ;
des moyens de calcul de la mesure statistique disposés pour calculer une mesure statistique de la valeur projetée ajustée de chaque maximum ; et
des moyens d'ajustement de l'intensité disposés pour ajuster l'intensité de chaque spectre échantillon en divisant les données spectrales par la valeur trouvée à l'étape de calcul d'une mesure statistique de la valeur projetée ajustée de chaque maximum de manière à ce que
les spectres échantillons soient normalisés et que la corrélation entre les caractéristiques spectroscopiques dans chaque spectre échantillon soit conservée.

6. Système selon la revendication 5, dans lequel les spectres témoins sont déterminés comme étant l'ensemble de spectres échantillons numériques.

7. Système selon l'une quelconque des revendications 5 à 6, dans lequel les moyens de sélection comprennent, en outre :
des moyens de sélection de la bande spectrale de chaque spectre échantillon comme étant l'ensemble de spectres témoins.

8. Système selon la revendication 5, dans lequel le rapport log est un logarithme de base 2.
